# EUROPEAN PATENT APPLICATION

(11) **EP 4 808 311 A1**
(43) Date of publication of application: **16.09.2026**
(21) Application number: 25181338.2
(22) Date of filing: 06.06.2025
(51) Int. Cl.: H10F 10/14, H10F 10/165, H10F 10/166, H10F 77/20, H10F 77/30, H10F 77/70

(54) **BACK CONTACT SOLAR CELL, MANUFACTURING METHOD THEREOF, AND PHOTOVOLTAIC MODULE**

(30) Priority: 10.03.2025 CN 202510278200
(71) Applicant: Zhejiang Jinko Solar Co., Ltd., Haining, Zhejiang 314416 (CN)
(72) Inventor: DUAN, Weiyuan, Haining, Zhejiang 314416 (CN); YANG, Jie, Haining, Zhejiang 314416 (CN); ZHANG, Xinyu, Haining, Zhejiang 314416 (CN)
(74) Representative: Herrero & Asociados, S.L.

(57) **Abstract**

A back contact solar cell, which includes: a substrate, the back surface including first doped regions and second doped regions arranged alternately, and the first doped region and the second doped region each including a first sub-region and a second sub-region; a first doped semiconductor layer located in a corresponding first doped region; a second doped semiconductor layer located in a corresponding second doped region; the first conductive portion located on a side of the first doped semiconductor layer away from the substrate, and the second conductive portion located on a side of the second doped semiconductor layer away from the substrate; and the first anti-reflection portions are located on sides of the first doped semiconductor layer and the second doped semiconductor layer away from the substrate and disposed corresponding to the second sub-region of the first doped region and the second sub-region of the second doped region.

## Description

### TECHNICAL FIELD

The present application relates to the technical field of solar cell manufacturing, and more particularly, to a back contact solar cell, a manufacturing method thereof, and a photovoltaic module.

### BACKGROUND

Interdigitated Back Contact (IBC) solar cell refers to a back-junction, back-contact solar cell structure in which positive and negative metal electrodes are arranged in an interdigitated manner on the backlight side of the cell, where its PN junction is located on the back surface of the cell. The "back-junction" herein means that the PN junction is located on the back surface of the cell. For the IBC solar cells, monocrystalline silicon is used as a substrate, both the PN junction and metal electrodes are located on the back surface of the cell, and no light-shielding metal electrodes are disposed on the front surface, thereby capable of obtaining high short-circuit current and conversion efficiency.

### SUMMARY

In view of this, it is necessary to address the problem in the related art where the bifaciality factor and the light utilization rate of back-contact solar cells still need improvement, by providing a back contact solar cell, a manufacturing method thereof, and a photovoltaic module.

In a first aspect, the present application provides a back contact solar cell, which includes:
a substrate having a front surface and a back surface disposed opposite to each other, the back surface including first doped regions and second doped regions arranged alternately, and the first doped region and the second doped region each including a first sub-region and a second sub-region;
a first doped semiconductor layer disposed corresponding to a corresponding first doped region, the first doped semiconductor layer containing a first doping element;
a second doped semiconductor layer disposed corresponding to a corresponding second doped region, the second doped semiconductor layer containing a second doping element, a conductivity type of the second doping element different from a conductivity type of the first doping element;
a transparent conductive layer including a plurality of first conductive portions and a plurality of second conductive portions, the first conductive portion located on a side of the first doped semiconductor layer away from the substrate and disposed at least corresponding to the first sub-region of the first doped region, and the second conductive portion located on a side of the second doped semiconductor layer away from the substrate and disposed at least corresponding to the first sub-region of the second doped region;
a first electrode disposed corresponding to the first sub-region of the first doped region and located on a side of the first conductive portion away from the substrate;
a second electrode disposed corresponding to the first sub-region of the second doped region and located on a side of the second conductive portion away from the substrate; and
a first anti-reflection layer including a plurality of first anti-reflection portions, the first anti-reflection portions being located on sides of the first doped semiconductor layer and the second doped semiconductor layer away from the substrate and disposed corresponding to the second sub-region of the first doped region and the second sub-region of the second doped region.

In some embodiments, the first conductive portion and the second conductive portion are both disposed to be in contact with the first anti-reflection portion adjacent thereto.

In some embodiments, a thickness of the transparent conductive layer ranges from 60 nanometers to 90 nanometers; and/ or a thickness of the first anti-reflection layer ranges from 60 nanometers to 90 nanometers.

In some embodiments, the transparent conductive layer is made of at least one of indium tin oxide, indium tungsten oxide, zinc aluminum oxide, titanium-doped indium oxide, and fluorine-doped tin oxide; and/or the first anti-reflection layer is made of at least one of silicon oxide, silicon nitride, and silicon oxynitride.

In some embodiments, the back contact solar cell further includes a first tunneling layer located between the substrate and the first doped semiconductor layer; and a first intrinsic amorphous silicon layer located between the substrate and the second doped semiconductor layer.

In some embodiments, the first intrinsic amorphous silicon layer is in contact with the first doped semiconductor layer adjacent thereto; and/or the first intrinsic amorphous silicon layer is in contact with the first tunneling layer adjacent thereto.

In some embodiments, a thickness of the first tunneling layer ranges from 0.5 nanometers to 2 nanometers; and/or
a thickness of the first intrinsic amorphous silicon layer ranges from 4 nanometers to 10 nanometers.

In another aspect, the present application further provides a method for manufacturing a back contact solar cell, including:
providing a substrate, the substrate having a front surface and a back surface disposed opposite to each other, the back surface including first doped regions and second doped regions arranged alternately, and the first doped region and the second doped region each including a first sub-region and a second sub-region;
forming a first doped semiconductor layer on the first doped region, the first doped semiconductor layer containing a first doping element;
forming a second doped semiconductor layer on the second doped region, the second doped semiconductor layer containing a second doping element, a conductivity type of the second doping element different from a conductivity type of the first doping element;
forming a transparent conductive layer on sides of the first doped semiconductor layer and the second doped semiconductor layer away from the substrate, the transparent conductive layer including a plurality of first conductive portions and a plurality of second conductive portions, the first conductive portion located on a side of the first doped semiconductor layer away from the substrate and disposed at least corresponding to the first sub-region of the first doped region, and the second conductive portion located on a side of the second doped semiconductor layer away from the substrate and disposed at least corresponding to the first sub-region of the second doped region;
forming a first electrode on a side of the first conductive portion away from the substrate;
forming a second electrode on a side of the second conductive portion away from the substrate; and
forming a first anti-reflection layer on sides of the first doped semiconductor layer and the second doped semiconductor layer away from the substrate, the first anti-reflection layer including a plurality of first anti-reflection portions, the first anti-reflection portions being located on sides of the first doped semiconductor layer and the second doped semiconductor layer away from the substrate and disposed corresponding to the second sub-region of the first doped region and the second sub-region of the second doped region.

In some embodiments, in the step of forming a first anti-reflection layer on sides of the first doped semiconductor layer and the second doped semiconductor layer away from the substrate, the first conductive portion and the second conductive portion are both disposed to be in contact with the first anti-reflection portion adjacent thereto.

In a still another aspect, the present application further provides a photovoltaic module, including:
a cell string formed by connecting a plurality of back contact solar cells in any of the embodiments described above, or a plurality of back contact solar cells manufactured by the manufacturing method in any of the embodiments described above;
a connecting component configured to electrically connect two adjacent back contact solar cells;
an encapsulating adhesive film configured to cover a surface of the cell string; and
a cover plate configured to cover a surface of the encapsulating adhesive film away from the cell string.

According to the embodiments of the present application, the first conductive portion and the second conductive portion are respectively disposed in the first doped region and the second doped region of the back surface. The first doped semiconductor layer and the first anti-reflection portion are sequentially stacked on the second sub-region of the first doped region of the back surface. The second doped semiconductor layer and the first anti-reflection portion are sequentially stacked on the second sub-region of the second doped region of the back surface. That is, in a direction parallel to a plane where the substrate is located, i.e., in a direction perpendicular to the thickness direction of the substrate, the first anti-reflection portion is at least located between the first conductive portion and the second conductive portion that are adjacent to each other, which achieves many beneficial effects. In an aspect, in the direction parallel to the plane where the substrate is located, the blank gap region between the first conductive portion and the second conductive portion no longer exists, and the first anti-reflection layer or the first anti-reflection portion can reduce the reflection of external light by the back surface, thereby improving the utilization rate of light by the back surface, and further improving the bifaciality factor of the solar cell. In another aspect, in the direction parallel to the plane where the substrate is located, there is no film layer of the transparent conductive layer between the first conductive portion and the second conductive portion. As an example, the film layer of the transparent conductive layer between the first conductive portion and the second conductive portion can be completely removed through an over-etching process. Although the high-energy particles for depositing the transparent conductive layer bombard the surface of the first doped region or the like and destroy the original film layer with a passivation effect, such as destroying the first doped semiconductor layer, or such as destroying the first tunneling layer, in the present application, the first anti-reflection layer is formed on the surfaces of the first doped semiconductor layer and the second doped semiconductor layer away from the substrate in the subsequent process, and the hydrogen element or the like during depositing the first anti-reflection layer can repair the destroyed film layer with the passivation effect. The hydrogen element or the like can repair the lattice defects in the destroyed film layer with the passivation effect, which improves the quality of crystals, and reduce the adverse impact of high-energy particles during deposition of the transparent conductive layer on passivation, thereby improving the photoelectric conversion efficiency of the solar cell. In a further aspect, the first anti-reflection portion is made of an insulating material, which can prevent a short circuit between the first conductive portion and the second conductive portion.

### BRIEF DESCRIPTION OF THE DRAWINGS

In order to illustrate the embodiments of the present application or the technical solutions in the exemplary examples more clearly, the drawings used in the embodiments or in the exemplary examples will be described briefly. Apparently, the following described drawings are merely for the embodiments of the present application, and other drawings can be derived based on these drawings by those of ordinary skill in the art without any creative effort.
FIG. 1 is a schematic view of a cross-sectional structure of a solar cell provided in an embodiment of the present application.
FIG. 2 is a schematic view of another cross-sectional structure of the solar cell provided in an embodiment of the present application.
FIG. 3 is a schematic view of still another cross-sectional structure of the solar cell provided in an embodiment of the present application.
FIG. 4 is a schematic view of a flow chart of a method for manufacturing a back contact solar cell provided in an embodiment of the present application.

### Reference signs:

100. back contact solar cell; 11. substrate; 31. first doped semiconductor layer; 32. second doped semiconductor layer; 40. transparent conductive layer; 61. first electrode; 62. second electrode; 50. first anti-reflection layer; 111. front surface; 112. back surface; 112a. first doped region; 112b. second doped region; 1121. first sub-region; 1122. second sub-region; 41. first conductive portion; 42. second conductive portion; 51. first anti-reflection portion; 21. first tunneling layer; 22. first intrinsic amorphous silicon layer; 12. passivation layer; 13. anti-reflection layer; X. first direction.

### DETAILED DESCRIPTION

The specific embodiments of the present application will now be described in detail with reference to the accompanying drawings in order to make the objectives, technical features, and advantages of the present application more clear.

In the following description, many specific details are set forth to provide a thorough understanding of the present application. However, the present application can be implemented in many other ways different from those described herein, and those skilled in the art can make similar modifications without departing from the spirit of the present application. Therefore, the present application is not limited by the specific embodiments disclosed below.

In the description of the present application, it should be understood that the terms "center", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential" etc. indicate the orientations or positional relationships on the basis of the drawings. These terms are only for the convenience of describing the present application and simplifying the description, rather than indicating or implying that the related devices or element must have the specific orientations, or be constructed or operated in the specific orientations, and therefore cannot be understood as limitations of the present application.

In addition, the terms "first" and "second" are only used for descriptive purposes and cannot be understood as indicating or implying relative importance or implicitly indicating the quantity or order of the indicated technical features. Therefore, the features modified by "first" or "second" may explicitly or implicitly include at least one of the features. In the description of the present application, the "plurality" means at least two, such as two, three, etc., unless otherwise specifically defined.

In the present application, unless otherwise clearly specified and defined, the terms "installed", "connected", "coupled", "fixed" and the like should be understood broadly. For example, an element, when being referred to as being "installed", "connected", "coupled", or "fixed" to another element, unless otherwise specifically defined, may be fixedly connected, detachably connected, or integrated to the other element, may be mechanical connected or electrically connected to the other element, and may be directly connected to the other element or connected to the other element via an intermediate medium, or may be internal communication between two elements or interaction between two elements, unless otherwise explicitly defined. For those skilled in the art, the specific meanings of the above terms in the present application can be understood according to specific circumstances.

In the present application, unless otherwise specifically defined, a first feature, when being referred to as being located "on" or "under" a second feature, may be in direct contact with the second feature, or in indirect contact with the second feature via an intermediate medium. Moreover, a first feature, when being referred to as being located "on", "above", "over" a second feature, may be located right above or obliquely above the second feature, or merely located at a horizontal level higher than the second feature. A first feature, when being referred to as being located "under", "below", "beneath" a second feature, may be located right below or obliquely below the second feature, or merely located at a horizontal level lower than the second feature.

It should be noted that an element, when being referred to as being "fixed", "disposed" or "mounted" to another element, may be directly fixed or mounted to the other element or via an intermediate element. An element, when being referred to as being "connected" to another element, may be directly connected to the other element or via an intermediate element. Terms "vertical", "horizontal", "up", "down", "left", "right" and the like used herein are for illustrative purposes only and are not meant to be the only manes for implementing the present application.

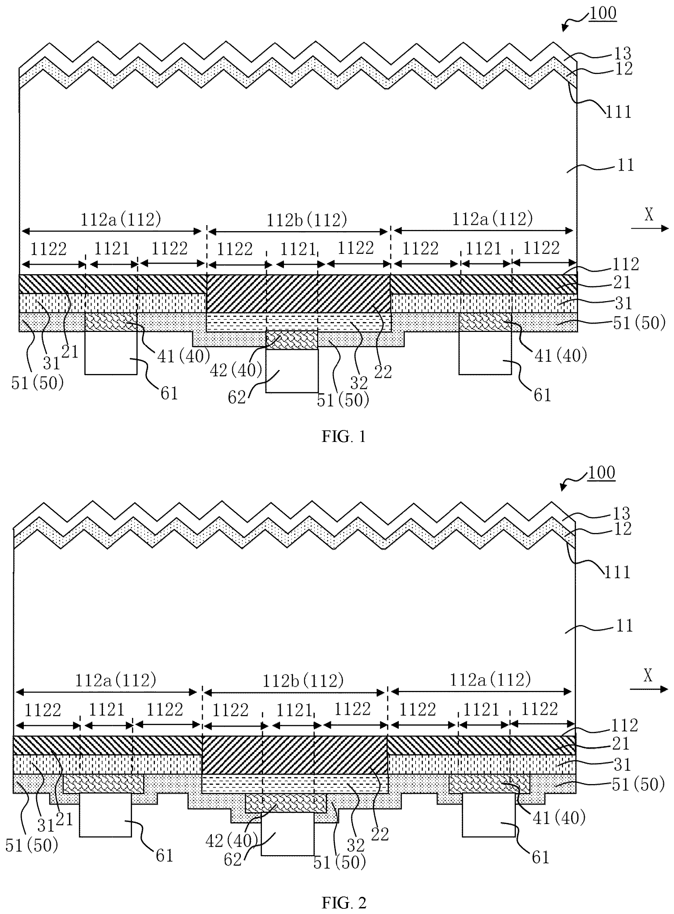

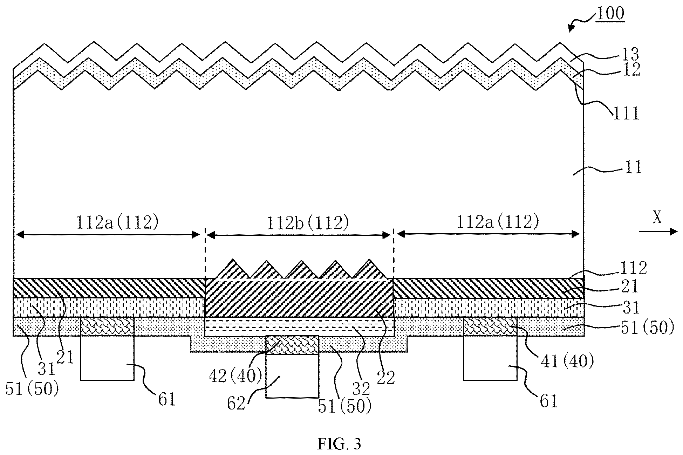

Referring to FIGS. 1 to 3, FIG. 1 is a schematic view of a cross-sectional structure of a solar cell provided in an embodiment of the present application, FIG. 2 is a schematic view of another cross-sectional structure of the solar cell provided in an embodiment of the present application, and FIG. 3 is a schematic view of still another cross-sectional structure of the solar cell provided in an embodiment of the present application.

In a first aspect, the present application provides a back contact solar cell 100. The back contact solar cell 100 includes a substrate 11, a first doped semiconductor layer 31, a second doped semiconductor layer 32, a transparent conductive layer 40, a first electrode 61, a second electrode 62, and a first anti-reflection layer 50. The substrate 11 has a front surface 111 and a back surface 112 disposed opposite to each other. The back surface 112 includes first doped regions 112a and second doped regions 112b arranged alternately. The first doped region 112a and the second doped region 112b each include a first sub-region 1121 and a second sub-region 1122. The first doped semiconductor layer 31 is disposed corresponding to a corresponding first doped region 112a, and the first doped semiconductor layer 31 contains a first doping element. The second doped semiconductor layer 32 is disposed corresponding to a corresponding second doped region 112b, and the second doped semiconductor layer 32 contains a second doping element, a conductivity type of the second doping element different from a conductivity type of the first doping element. The transparent conductive layer 40 includes a plurality of first conductive portions 41 and a plurality of second conductive portions 42. The first conductive portion 41 is located on a side of the first doped semiconductor layer 31 away from the substrate 11, and is disposed at least corresponding to the first sub-region 1121 of the first doped region 112a. The second conductive portion 42 is located on a side of the second doped semiconductor layer 32 away from the substrate 11, and is disposed at least corresponding to the first sub-region 1121 of the second doped region 112b. The first electrode 61 is disposed corresponding to the first sub-region 1121 of the first doped region 112a, and is located on a side of the first conductive portion 41 away from the substrate 11. The second electrode 62 is disposed corresponding to the first sub-region 1121 of the second doped region 112b, and is located on a side of the second conductive portion 42 away from the substrate 11. The first anti-reflection layer 50 includes a plurality of first anti-reflection portions 51. The first anti-reflection portions 51 are located on sides of the first doped semiconductor layer 31 and the second doped semiconductor layer 32 away from the substrate 11, and are disposed corresponding to the second sub-region 1122 of the first doped region 112a and the second sub-region 1122 of the second doped region 112b.

As an example, the substrate 11 can contain a doping element, and the doping element type is N-type or P-type. The N-type element can be a V-group element, such as phosphorus (P) bismuth (Bi) antimony (Sb) or arsenic (As). The P-type element can be a III-group element, such as boron (B) aluminum (Al) gallium (Ga) or indium (In). As an example, when the substrate 11 is a P-type substrate, the doping element in the substrate is P-type element. For another example, when the substrate 11 is an N-type substrate, the doping element in the substrate is N-type element.

As an example, the substrate 11 has a front surface 111 and a back surface 112 disposed opposite to each other. The front surface 111 and the back surface 112 are disposed opposite to each other along a thickness direction of the substrate 11. The front surface 111 and the back surface 112 both can be configured to receive incident light. In an embodiment of the present application, the front surface 111 of the substrate 11 is a primary light-receiving surface, and the back surface 112 of the substrate 11 is a secondary light-receiving surface. It can be understood that a light-receiving surface and a backlight surface are relative terms, and the light-receiving surface specifically refers to a surface of the substrate 11 of the back contact solar cell or a photovoltaic module where sunlight mainly irradiates. With the development of solar cell technology, the backlight surface can also receive energy from sunlight, mainly from reflected light or scattered light in a surrounding environment.

As an example, the back surface 112 includes first doped regions 112a and second doped regions 112b arranged alternately. The first doped region 112a and the second doped region 112b each include a first sub-region 1121 and a second sub-region 1122. The first sub-region 1121 can be a region corresponding to the first electrode 61 or the second electrode 62, and the first sub-region 1121 can be understood as a metal contact region. The second sub-region 1122 can be a region outside the first sub-region 1121, and the second sub-region 1122 can be understood as a non-metal contact region.

As an example, in some embodiments, as shown in FIG. 1, the first doped regions 112a and the second doped regions 112b are alternately arranged at least in a first direction X.

As an example, in some embodiments, as shown in FIG. 1, in the first direction X, a width of the metal contact region is greater than a width of the corresponding first electrode 61, and/or a width of the metal contact region is greater than a width of the corresponding second electrode 62, but is not limited thereto. As an example, due to process errors, the width of the metal contact region can be set to be greater than the width of the corresponding first electrode 61, and the width of the metal contact region can be set to be greater than the width of the corresponding second electrode 62, which ensures that the first electrode 61 is located in the corresponding metal contact region, and the second electrode 62 is located in the corresponding metal contact region.

As an example, in FIG. 1, on the first sub-region 1121 of the first doped region 112a of the back surface 112, the first doped semiconductor layer 31, the first conductive portion 41, and the first electrode 61 are sequentially stacked. An orthographic projection of the first electrode 61 on the back surface 112 is located within an orthographic projection of the first conductive portion 41 on the back surface 112. That is, the first electrode 61 is electrically connected to the first doped semiconductor layer 31 through the first conductive portion 41.

As an example, in Fig. 1, on the first sub-region 1121 of the second doped region 112b of the back surface 112, the second doped semiconductor layer 32, the second conductive portion 42, and the second electrode 62 are sequentially stacked. An orthographic projection of the second electrode 62 on the back surface 112 is located within an orthographic projection of the second conductive portion 42 on the back surface 112. That is, the second electrode 62 is electrically connected to the second doped semiconductor layer 32 through the second conductive portion 42.

As an example, the first doped semiconductor layer 31 contains a first doping element, and the second doped semiconductor layer 32 contains a second doping element having a conductivity type different from that of the first doping element. One of the first doping element and the second doping element is an N-type doping element, and the other of the first doping element and the second doping element is a P-type doping element. In the present application, it is exemplified that the first doping element is an N-type doping element, and the second doping element is a P-type doping element.

As an example, in FIG. 1, on the second sub-region 1122 of the first doped region 112a of the back surface 112, the first doped semiconductor layer 31 and the first anti-reflection portion 51 are sequentially stacked.

As an example, in FIG. 1, on the second sub-region 1122 of the second doped region 112b of the back surface 112, the second doped semiconductor layer 32 and the first anti-reflection portion 51 are sequentially stacked.

As an example, the first anti-reflection layer 50 or the first anti-reflection portion 51 is configured to reduce the reflection of external light by the back surface 112, thereby improving the utilization rate of light by the back surface 112, and further improving the bifaciality factor of the solar cell.

As an example, there is still a need in the existing technology to improve the bifaciality factor and the light utilization rate of the back contact solar cell, and the reasons found by the present inventors include the following. 1) In the existing technology, since a transparent conductive oxide (TCO) layer is used as an emission and transmission layer of the back surface 112, the transparent conductive oxide between the first doped region 112a and the second doped region 112b will be removed to prevent electric leakage in the first doped region 112a and the second doped region 112b through the transparent conductive oxide. As an example, a spacer region is disposed between the first doped region 112a and the second doped region 112b, and the transparent conductive oxide in the spacer region is removed, thereby preventing electric leakage in the first doped region 112a and the second doped region 112b through the transparent conductive oxide. However, the transparent conductive oxide covers the entire first doped region 112a and the entire second doped region 112b, and the transparent conductive oxide has a large parasitic absorption of short waves, which reduces the light utilization rate, thereby reducing the bifaciality factor of the solar cell. 2) In addition, during the deposition of the transparent conductive oxide, the high-energy particles for depositing the transparent conductive oxide bombard the surface of the first doped region 112, which destroy the original film layer with a passivation effect, such as the first doped semiconductor layer 31, such as the first tunneling layer 21, thereby reducing the passivation effect of the first doped region 112a, where such damage in the first doped region 112a is difficult to be repaired in subsequent process. In order to solve at least one of the above problems, some embodiments are proposed by the present inventors.

In an embodiment of the present application, the first conductive portion 41 and the second conductive portion 42 are respectively disposed in the first doped region 112a and the second doped region 112b of the back surface 112. The first doped semiconductor layer 31 and the first anti-reflection portion 51 are sequentially stacked on the second sub-region 1122 of the first doped region 112a of the back surface 112. The second doped semiconductor layer 32 and the first anti-reflection portion 51 are sequentially stacked on the second sub-region 1122 of the second doped region 112b of the back surface 112. That is, in a direction parallel to a plane where the substrate 11 is located, i.e., in a direction perpendicular to the thickness direction of the substrate 11, the first anti-reflection portion 51 is at least located between the first conductive portion 41 and the second conductive portion 42 that are adjacent to each other, which achieves many beneficial effects. In an aspect, in the direction parallel to the plane where the substrate 11 is located, the blank gap region between the first conductive portion 41 and the second conductive portion 42 no longer exists, and the first anti-reflection layer 50 or the first anti-reflection portion 51 can reduce the reflection of external light by the back surface 112, thereby improving the utilization rate of light by the back surface 112, and further improving the bifaciality factor of the solar cell. In another aspect, in the direction parallel to the plane where the substrate 11 is located, there is no film layer of the transparent conductive layer 40 between the first conductive portion 41 and the second conductive portion 42. As an example, the film layer of the transparent conductive layer 40 between the first conductive portion 41 and the second conductive portion 42 can be completely removed through an over-etching process. Although the high-energy particles for depositing the transparent conductive layer 40 bombard the surface of the first doped region 112a or the like and destroy the original film layer with a passivation effect, such as destroying the first doped semiconductor layer 31, or such as destroying the first tunneling layer 21, in the present application, the first anti-reflection layer 50 is formed on the surfaces of the first doped semiconductor layer 31 and the second doped semiconductor layer 32 away from the substrate 11 in the subsequent process, and the hydrogen element or the like during depositing the first anti-reflection layer 50 can repair the destroyed film layer with the passivation effect. The hydrogen element or the like can repair the lattice defects in the destroyed film layer with the passivation effect, which improves the quality of crystals, and reduce the adverse impact of high-energy particles during deposition of the transparent conductive layer 40 on passivation, thereby improving the photoelectric conversion efficiency of the solar cell. In a further aspect, the first anti-reflection portion 51 is made of an insulating material, which can prevent a short circuit between the first conductive portion 41 and the second conductive portion 42.

In some embodiments, as shown in FIG. 1, the first conductive portion 41 and the second conductive portion 42 are both disposed to be in contact with the first anti-reflection portion 51 adjacent thereto.

As an example, the first conductive portion 41 and the second conductive portion 42 are both disposed to be in contact with the first anti-reflection portion 51 adjacent thereto. That is, in the direction parallel to the plane where the substrate 11 is located, for example, in a direction parallel to the paper or the desktop in FIG. 1, or for example, in the first direction X in FIG. 1, an end face of the first conductive portion 41 is disposed to be in contact with the first anti-reflection portion 51 adjacent thereto, and an end face of the second conductive portion 42 is disposed to be in contact with the same adjacent first anti-reflection portion 51, so that there is no gap between the first conductive portion 41 and the second conductive portion 42, and the same adjacent first anti-reflection portion 51 in the direction parallel to the plane where the substrate 11 is located. Meanwhile, the area of the first anti-reflection portion 51 is increased, which further reduces the reflection of external light by the back surface 112, thereby improving the utilization rate of light by the back surface 112, and further improving the bifaciality factor of the solar cell.

In some embodiments, as shown in FIG. 1, a thickness of the transparent conductive layer 40 ranges from 60 nanometers to 90 nanometers; and/ or a thickness of the first anti-reflection layer 50 ranges from 60 nanometers to 90 nanometers.

As an example, the thickness of the transparent conductive layer 40 can be any value selected from 60 nanometers, 65 nanometers, 70 nanometers, 75 nanometers, 80 nanometers, 85 nanometers, and 90 nanometers.

As an example, the thickness of the first anti-reflection layer 50 can be any value selected from 60 nanometers, 65 nanometers, 70 nanometers, 75 nanometers, 80 nanometers, 85 nanometers, and 90 nanometers.

As an example, it is found by the inventors through research that when the thickness of the transparent conductive layer 40 ranges from 60 nanometers to 90 nanometers, not only the first conductive portion 41 and the second conductive portion 42 have good electrical transmission performance, but also the adverse impact on passivation caused by the deposition of an excessively thick transparent conductive layer 40 is prevented.

As an example, it is further found by the inventors through research that when the thickness of the first anti-reflection layer 50 ranges from 60 nanometers to 90 nanometers, not only the first anti-reflection portion 51 has good anti-reflection performance, but also the material of the first anti-reflection layer 50 on surfaces of the first electrode 61 and the second electrode 62 away from the substrate 11 can be easily removed.

In some embodiments, the transparent conductive layer 40 is made of at least one of indium tin oxide, indium tungsten oxide, zinc aluminum oxide, titanium-doped indium oxide, and fluorine-doped tin oxide; and/or the first anti-reflection layer 50 is made of at least one of silicon oxide, silicon nitride, and silicon oxynitride.

In some embodiments, the back contact solar cell 100 further includes a first tunneling layer 21 and a first intrinsic amorphous silicon layer 22. The first tunneling layer 21 is located between the substrate 11 and the first doped semiconductor layer 31. The first intrinsic amorphous silicon layer 22 is located between the substrate 11 and the second doped semiconductor layer 32.

As an example, the first tunneling layer 21 can be made of silicon oxide, but is not limited thereto.

As an example, in FIG. 1, on the first sub-region 1121 of the first doped region 112a of the back surface 112, the first tunneling layer 21, the first doped semiconductor layer 31, the first conductive portion 41, and the first electrode 61 are sequentially stacked.

As an example, in FIG. 1, on the first sub-region 1121 of the second doped region 112b of the back surface 112, the first intrinsic amorphous silicon layer 22, the second doped semiconductor layer 32, the second conductive portion 42, and the second electrode 62 are sequentially stacked.

As an example, as shown in FIG. 1, the back contact solar cell 100 of the present application has a heterostructure. The first intrinsic amorphous silicon layer 22 and the second doped semiconductor layer 32 are sequentially disposed in the second doped region 112b, and the second doped semiconductor layer 32 can be P-type amorphous silicon.

In some embodiments, as shown in FIG. 1, the first intrinsic amorphous silicon layer 22 is in contact with the first doped semiconductor layer 31 adjacent thereto; and/or the first intrinsic amorphous silicon layer 22 is in contact with the first tunneling layer 21 adjacent thereto.

As an example, as shown in FIG. 1, in the direction parallel to the plane where the substrate 11 is located, an end face of the first intrinsic amorphous silicon layer 22 is in contact with the first doped semiconductor layer 31 adjacent thereto, which can increase the area of the first intrinsic amorphous silicon layer 22 and/or the area of the first doped semiconductor layer 31, thereby increasing the area of the back surface 112 receiving sunlight, and further increasing the bifaciality factor of the solar cell.

As an example, as shown in FIG. 1, in the direction parallel to the plane where the substrate 11 is located, an end face of the first intrinsic amorphous silicon layer 22 is in contact with the first tunneling layer 21 adjacent thereto, which can increase the area of the first intrinsic amorphous silicon layer 22 and/ or the area of the first tunneling layer 21, thereby increasing the area of the back surface 112 receiving sunlight, and further increasing the bifaciality factor of the solar cell.

In some embodiments, as shown in FIG. 1, a thickness of the first tunneling layer 21 ranges from 0.5 nanometers to 2 nanometers; and/or a thickness of the first intrinsic amorphous silicon layer 22 ranges from 4 nanometers to 10 nanometers.

As an example, as shown in FIG. 1, in the direction perpendicular to the plane where the substrate 11 is located, i.e., in the thickness direction of the substrate 11, the thickness of the first tunneling layer 21 ranges from 0.5 nanometers to 2 nanometers, for example, can be any value selected from 0.5 nanometers, 1 nanometer, 1.5 nanometers, and 2 nanometers.

As an example, as shown in FIG. 1, in the direction perpendicular to the plane where the substrate 11 is located, i.e., in the thickness direction of the substrate 11, the thickness of the first intrinsic amorphous silicon layer 22 ranges from 4 nanometers to 10 nanometers, for example, can be any value selected from 4 nanometers, 6 nanometers, 8 nanometers, and 10 nanometers.

As an example, as shown in FIG. 1, the thickness of the first intrinsic amorphous silicon layer 22 is more than the thickness of the first tunneling layer 21, so that the first intrinsic amorphous silicon layer 22 can be in contact with the first doped semiconductor layer 31 adjacent thereto; and/or the first intrinsic amorphous silicon layer 22 can be in contact with the first tunneling layer 21 adjacent thereto.

It should be noted that, a thickness of the first doped semiconductor layer 31 ranges from 30 nanometers to 180 nanometers, for example, can be any value selected from 30 nanometers, 50 nanometers, 70 nanometers, 80 nanometers, 100 nanometers, 120 nanometers, 150 nanometers, and 180 nanometers. A thickness of the second doped semiconductor layer 32 ranges from 6 nanometers to 20 nanometers, for example, can be any value selected from 6 nanometers, 10 nanometers, 12 nanometers, 15 nanometers, 18 nanometers, and 20 nanometers.

It should be noted that, as shown in FIG. 1, in the direction parallel to the plane where the substrate 11 is located, for example, also in a direction parallel to the paper or the desktop in FIG. 2, a width of the first conductive portion 41 can be set equal to a width of the first electrode 61, and an edge of the first conductive portion 41 is flush with an edge of the first electrode 61. In the direction parallel to the plane where the substrate 11 is located, for example, also in the direction parallel to the paper or the desktop in FIG. 2, a width of the second conductive portion 42 can be set equal to a width of the second electrode 62, and an edge of the second conductive portion 42 is flush with an edge of the second electrode 62.

It should be noted that, as shown in FIG. 2, since there can be process errors when the first electrode 61 is prepared on the first conductive portion 41, and there can be process errors when the second electrode 62 is prepared on the second conductive portion 42, in the direction parallel to the plane where the substrate 11 is located, for example, also in the direction parallel to the paper or the desktop in FIG. 2, the width of the first conductive portion 41 can be set to be greater than the width of the first electrode 61, and a part of the first conductive portion 41 is disposed on the second sub-region 1122 of the first doped region 112 a; the width of the second conductive portion 42 can be set to be greater than the width of the second electrode 62, and a part of the second conductive portion 42 is disposed on the second sub-region 1122 of the second doped region 112 b. In this case, a part of the surface of the first conductive portion 41 away from the substrate 11 is exposed by the first electrode 61 and covered by the first anti-reflection portion 51, and a part of the surface of the second conductive portion 42 away from the substrate 11 is exposed by the second electrode 62 and covered by the first anti-reflection portion 51, which can reduce the reflection of sunlight on the first conductive portion 41 and the second conductive portion 42, thereby improving the utilization rate of sunlight.

It should be noted that FIG. 1 and FIG. 2 illustrate that the second doped region 112b of the back surface 112 is a flat surface. As shown in FIG. 3, the second doped region 112b of the back surface 112 can be a textured surface, which can further increase the contact area between the first intrinsic amorphous silicon layer 22 and the surface of the second doped region 112b, thereby improving the passivation effect of the first intrinsic amorphous silicon layer 22 on the second doped region 112b. Meanwhile, the conductive area of the second doped region 112b can be further increased, which is conducive to improving the photoelectric conversion efficiency of the back contact heterojunction solar cell.

It should be noted that the back contact solar cell 100 further includes a passivation layer 12 and an anti-reflection layer 13 which are sequentially stacked on the front surface 111. The passivation layer 12 can be made of at least one of aluminum oxide (AlOx) silicon oxide (SiOx) amorphous silicon (a-Si:H (i)) etc. The anti-reflection layer 13 can be made of at least one of silicon oxynitride (SiNxOy) and silicon nitride (SiNx).

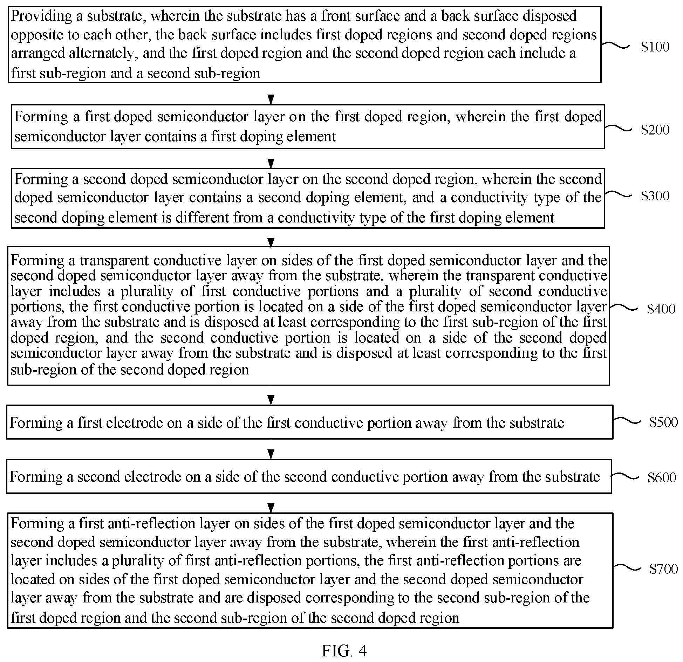

Referring to FIG. 4, FIG. 4 is a schematic view of a flow chart of a method for manufacturing a back contact solar cell provided in an embodiment of the present application.

In a second aspect, based on the same application concept, the present application further provides a method for manufacturing a back contact solar cell. The back contact solar cell 100 in any of the above embodiments can be manufactured by the method for manufacturing a back contact solar cell. The method for manufacturing a back contact solar cell includes: a step S100, a step S200, a step S300, a step S400, a step S500, a step S600, and a step S700.

Step S100, providing a substrate, wherein the substrate has a front surface and a back surface disposed opposite to each other, the back surface includes first doped regions and second doped regions arranged alternately, and the first doped region and the second doped region each include a first sub-region and a second sub-region.

As an example, the substrate 11 is provided. The substrate 11 has the front surface 111 and the back surface 112 disposed opposite to each other. The back surface 112 includes the first doped regions 112a and the second doped regions 112b arranged alternately. The first doped region 112a and the second doped region 112b each include the first sub-region 1121 and the second sub-region 1122.

Step S200: forming a first doped semiconductor layer on the first doped region, wherein the first doped semiconductor layer contains a first doping element.

As an example, the first doped semiconductor layer 31 is formed on the first doped region 112a, and the first doped semiconductor layer 31 contains the first doping element.

Step S300: forming a second doped semiconductor layer on the second doped region, wherein the second doped semiconductor layer contains a second doping element, and a conductivity type of the second doping element is different from a conductivity type of the first doping element.

As an example, the second doped semiconductor layer 32 is formed on the second doped region 112b, and the second doped semiconductor layer 32 contains the second doped element having a conductivity type different from that of the first doped element.

Step S400, forming a transparent conductive layer on sides of the first doped semiconductor layer and the second doped semiconductor layer away from the substrate, wherein the transparent conductive layer includes a plurality of first conductive portions and a plurality of second conductive portions, the first conductive portion is located on a side of the first doped semiconductor layer away from the substrate and is disposed at least corresponding to the first sub-region of the first doped region, and the second conductive portion is located on a side of the second doped semiconductor layer away from the substrate and is disposed at least corresponding to the first sub-region of the second doped region.

As an example, the transparent conductive layer 40 is formed on sides of the first doped semiconductor layer 31 and the second doped semiconductor layer 32 away from the substrate 11. The transparent conductive layer 40 includes a plurality of first conductive portions 41 and a plurality of second conductive portions 42. The first conductive portion 41 is located on the side of the first doped semiconductor layer 31 away from the substrate 11 and is disposed at least corresponding to the first sub-region 1121 of the first doped region 112a. The second conductive portion 42 is located on the side of the second doped semiconductor layer 32 away from the substrate 11 and is disposed at least corresponding to the first sub-region 1121 of the second doped region 112b.

Step S500: forming a first electrode on a side of the first conductive portion away from the substrate.

As an example, the first electrode 61 is formed on the side of the first conductive portion 41 away from the substrate 11.

Step S600: forming a second electrode on a side of the second conductive portion away from the substrate.

As an example, the second electrode 62 is formed on the side of the second conductive portion 42 away from the substrate 11.

Step S700, forming a first anti-reflection layer on sides of the first doped semiconductor layer and the second doped semiconductor layer away from the substrate, wherein the first anti-reflection layer includes a plurality of first anti-reflection portions, the first anti-reflection portions are located on sides of the first doped semiconductor layer and the second doped semiconductor layer away from the substrate and are disposed corresponding to the second sub-region of the first doped region and the second sub-region of the second doped region.

As an example, the first anti-reflection layer 50 is formed on sides of the first doped semiconductor layer 31 and the second doped semiconductor layer 32 away from the substrate 11. The first anti-reflection layer 50 includes a plurality of first anti-reflection portions 51. The first anti-reflection portions 51 are located on sides of the first doped semiconductor layer 31 and the second doped semiconductor layer 32 away from the substrate 11 and are disposed corresponding to the second sub-region 1122 of the first doped region 112a and the second sub-region 1122 of the second doped region 112b.

In some embodiments, in the step S700 of forming the first anti-reflection layer 50 on sides of the first doped semiconductor layer 31 and the second doped semiconductor layer 32 away from the substrate 11, the first conductive portion 41 and the second conductive portion 42 are both disposed to be in contact with the first anti-reflection portion 51 adjacent thereto.

As an example, in combination with the multiple steps of the manufacturing method for the back contact solar cell, specific steps of the manufacturing method for the back contact solar cell in one embodiment is further described in detail as follows: 1) step S100, providing the substrate 11, and cleaning and polishing the substrate 11; 2) forming a first tunneling layer 21 made of a pre-determined material, for example, a tunneling layer made of SiOx, on the back surface 112; 3) step S200, forming a polysilicon layer on a side of the first tunneling layer 21 made of the pre-determined material away from the substrate 11, and then performing N-type doping to form a first doped semiconductor layer 31 made of a pre-determined material; 4) patterning the film layers on the back surface 112 to remove the phosphosilicate glass layer (PSG) in the second doped region 112b and retain the first tunneling layer 21 and the first doped semiconductor layer 31 in the first doped region 112a; 5) removing the phosphosilicate glass layer (PSG) on the single front surface 111 by hydrofluoric acid; 6) double-sided etching and texturing; 7) removing the phosphosilicate glass layer (PSG) in the first doped region 112a of the back surface by hydrofluoric acid and then cleaning; 8) forming a passivation layer 12 made of at least one of AlOx, SiOx, a-Si:H (i) or the like on the front surface 111; 9) forming an anti-reflection layer 13 made of at least one of SiNxOy and SiNx on the front surface 111; 10) performing chain-type wrap-around removal on the back surface to remove materials of the passivation layer 12 and the anti-reflection layer 13 on the back surface 112; 11) annealing to improve the passivation level; 12) cleaning, for example, cleaning the surface of the second doped region 112b; 13) forming the first intrinsic amorphous silicon layer 22 made of a pre-determined material on the entire back surface 112, for example, depositing an amorphous silicon layer at a temperature below 250°C; 14) step S300, forming the second doped semiconductor layer 32 made of a pre-determined material on the entire back surface 112, for example, depositing a P-type doped silicon thin film layer which can be made of one or more of a-Si:H (p), nc-Si:H(p), and nc-SiOx:H(p) at a temperature below 250°C; 15) patterning the first intrinsic amorphous silicon layer 22 made of a pre-determined material and the second doped semiconductor layer 32 made of a pre-determined material on the back surface 112, to only retain the first intrinsic amorphous silicon layer 22 and the second doped semiconductor layer 32 in the second doped region 112b; 16) step S400, forming the transparent conductive layer 40 made of a pre-determined material on the entire back surface 112; 17) patterning the transparent conductive layer 40 to form a plurality of first conductive portions 41 and a plurality of second conductive portions 42; 18) steps S500 and S600, forming the first electrode 61 and the second electrode 62 on the back surface; 19) step S700, forming the first anti-reflection layer 50 on the back surface 112, for example, depositing SiNxOy at a temperature below 250°C.

In a third aspect, based on the same application concept, the present application further provides a photovoltaic module. The photovoltaic module includes a cell string, a connecting component, an encapsulating adhesive film, and a cover plate. The cell string is formed by connecting a plurality of back contact solar cells 100 in any of the above embodiments. Alternatively, the cell string is formed by connecting a plurality of back contact solar cells 100 manufactured by the manufacturing method in any of the above embodiments. The connecting component is configured to electrically connect two adjacent back contact solar cells 100. The encapsulating adhesive film is configured to cover a surface of the cell string. The cover plate is configured to cover a surface of the encapsulating adhesive film away from the cell string.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. Therefore, the patent protection of the present application shall be defined by the appended claims.

## Claims

1. A back contact solar cell (100), comprising:
a substrate (11) having a front surface (111) and a back surface (112) disposed opposite to each other, the back surface (112) comprising first doped regions (112a) and second doped regions (112b) arranged alternately, and the first doped region (112a) and the second doped region (112b) each comprising a first sub-region (1121) and a second sub-region (1122);
a first doped semiconductor layer (31) disposed corresponding to a corresponding first doped region (112a), the first doped semiconductor layer (31) containing a first doping element;
a second doped semiconductor layer (32) disposed corresponding to a corresponding second doped region (112b), the second doped semiconductor layer (32) containing a second doping element, a conductivity type of the second doping element different from a conductivity type of the first doping element;
a transparent conductive layer (40) comprising a plurality of first conductive portions (41) and a plurality of second conductive portions (42), the first conductive portion located on a side of the first doped semiconductor layer away from the substrate and disposed at least corresponding to the first sub-region of the first doped region, and the second conductive portion (42) located on a side of the second doped semiconductor layer (32) away from the substrate (11) and disposed at least corresponding to the first sub-region (1121) of the second doped region (112b);
a first electrode (61) disposed corresponding to the first sub-region (1121) of the first doped region (112a) and located on a side of the first conductive portion (41) away from the substrate (11);
a second electrode (62) disposed corresponding to the first sub-region (1121) of the second doped region (112b) and located on a side of the second conductive portion (42) away from the substrate (11); and
a first anti-reflection layer (50) comprising a plurality of first anti-reflection portions (51), the first anti-reflection portions (51) being located on sides of the first doped semiconductor layer (31) and the second doped semiconductor layer (32) away from the substrate (11) and disposed corresponding to the second sub-region (1122) of the first doped region (112a) and the second sub-region (1122) of the second doped region (112b).

2. The back contact solar cell (100) according to claim 1, wherein the first conductive portion (41) and the second conductive portion (42) are both disposed to be in contact with the first anti-reflection portion (51) adjacent thereto.

3. The back contact solar cell (100) according to claim 1 or 2, wherein a thickness of the transparent conductive layer (40) ranges from 60 nanometers to 90 nanometers; and/ or
a thickness of the first anti-reflection layer (50) ranges from 60 nanometers to 90 nanometers.

4. The back contact solar cell (100) according to any one of claims 1 to 3, wherein
the transparent conductive layer (40) is made of at least one of indium tin oxide, indium tungsten oxide, zinc aluminum oxide, titanium-doped indium oxide, and fluorine-doped tin oxide; and/or
the first anti-reflection layer (50) is made of at least one of silicon oxide, silicon nitride, and silicon oxynitride.

5. The back contact solar cell (100) according to any one of claims 1 to 4, further comprising
a first tunneling layer (21) located between the substrate (11) and the first doped semiconductor layer (31); and
a first intrinsic amorphous silicon layer (22) located between the substrate (11) and the second doped semiconductor layer (32).

6. The back contact solar cell (100) according to claim 5, wherein
the first intrinsic amorphous silicon layer (22) is in contact with the first doped semiconductor layer (31) adjacent thereto; and/or
the first intrinsic amorphous silicon layer (22) is in contact with the first tunneling layer (21) adjacent thereto.

7. The back contact solar cell (100) according to claim 5, wherein
a thickness of the first tunneling layer (21) ranges from 0.5 nanometers to 2 nanometers; and/or
a thickness of the first intrinsic amorphous silicon layer (22) ranges from 4 nanometers to 10 nanometers.

8. The back contact solar cell (100) according to any of claims 1 to 7, wherein in a first direction,
a width of the first sub-region (1121) is greater than a width of the corresponding first electrode (61); and/or
in a first direction, a width of the first sub-region (1121) is greater than a width of the corresponding second electrode (62).

9. The back contact solar cell (100) according to claim 5, wherein on the first sub-region (1121) of the first doped region (112a) of the back surface (112), the first tunneling layer (21), the first doped semiconductor layer (31), the first conductive portion (41), and the first electrode (61) are sequentially stacked.

10. The back contact solar cell (100) according to claim 5, wherein on the first sub-region (1121) of the second doped region (112b) of the back surface (112), the first intrinsic amorphous silicon layer (22), the second doped semiconductor layer (32), the second conductive portion (42), and the second electrode (62) are sequentially stacked.

11. The back contact solar cell (100) according to any of claims 1 to 10, wherein the back contact solar cell has a heterostructure.

12. The back contact solar cell (100) according to any of claims 1 to 11, wherein the back contact solar cell further comprises a passivation layer (12) and an anti-reflection layer (13) which are sequentially stacked on the front surface (111).

13. A method for manufacturing a back contact solar cell (100), comprising:
providing a substrate (11), the substrate (11) having a front surface (111) and a back surface (112) disposed opposite to each other, the back surface (112) comprising first doped regions (112a) and second doped regions (112b) arranged alternately, and the first doped region (112a) and the second doped region (112b) each comprising a first sub-region (1121) and a second sub-region (1122);
forming a first doped semiconductor layer (31) on the first doped region (112a), the first doped semiconductor layer (31) containing a first doping element;
forming a second doped semiconductor layer (32) on the second doped region (112b), the second doped semiconductor layer (32) containing a second doping element, a conductivity type of the second doping element different from a conductivity type of the first doping element;
forming a transparent conductive layer (40) on sides of the first doped semiconductor layer (31) and the second doped semiconductor layer (32) away from the substrate (11), the transparent conductive layer (40) comprising a plurality of first conductive portions (41) and a plurality of second conductive portions (42), the first conductive portion (41) located on a side of the first doped semiconductor layer (31) away from the substrate (11) and disposed at least corresponding to the first sub-region (1121) of the first doped region (112a), and the second conductive portion (42) located on a side of the second doped semiconductor layer (32) away from the substrate (11) and disposed at least corresponding to the first sub-region (1121) of the second doped region (112b);
forming a first electrode (61) on a side of the first conductive portion (41) away from the substrate (11);
forming a second electrode (62) on a side of the second conductive portion (42) away from the substrate (11); and
forming a first anti-reflection layer (50) on sides of the first doped semiconductor layer (31) and the second doped semiconductor layer (32) away from the substrate (11), the first anti-reflection layer (50) comprising a plurality of first anti-reflection portions (51), the first anti-reflection portions (51) being located on sides of the first doped semiconductor layer (31) and
the second doped semiconductor layer (32) away from the substrate (11) and disposed corresponding to the second sub-region (1122) of the first doped region (112a) and the second sub-region (1122) of the second doped region (112b).

14. The method for manufacturing the back contact solar cell (100) according to claim 13, wherein in the step of forming a first anti-reflection layer (50) on sides of the first doped semiconductor layer (31) and the second doped semiconductor layer (32) away from the substrate (11), the first conductive portion (41) and the second conductive portion (42) are both disposed to be in contact with the first anti-reflection portion (51) adjacent thereto.

15. A photovoltaic module, comprising
a cell string formed by connecting a plurality of back contact solar cells (100) according to any one of claims 1 to 12 or a plurality of back contact solar cells (100) manufactured by the method according to claim 13 or 14;
a connecting component configured to electrically connect two adjacent back contact solar cells (100);
an encapsulating adhesive film configured to cover a surface of the cell string; and
a cover plate configured to cover a surface of the encapsulating adhesive film away from the cell string.
